# EUROPEAN PATENT APPLICATION

(11) **EP 4 582 301 A1**
(43) Date of publication of application: **09.07.2025**
(21) Application number: 24222412.9
(22) Date of filing: 20.12.2024
(51) Int. Cl.: B60L 53/302

(54) **COOLING DEVICE, COOLING SYSTEM AND CHARGING DEVICE**

(30) Priority: 29.12.2023 CN 202311869732
(71) Applicant: Tyco Electronics (Suzhou) Ltd., Suzhou City, Jiangsu Province 215126 (CN); Tyco Electronics Technology (SIP) Ltd., Suzhou 215026 (CN); Tyco Electronics (Shanghai) Co., Ltd., Pilot Free Trade Zone Shanghai 200131 (CN)
(72) Inventor: Wu, Super, Suzhou, 32 215123 (CN); Jiang, Kaixuan, Shanghai, 200233 (CN); Zhu, Fangyue, Shanghai, 200233 (CN); Wang, Jinshun, Suzhou, 32 215123 (CN)
(74) Representative: Grünecker Patent- und Rechtsanwälte PartG mbB

(57) **Abstract**

The present invention discloses a cooling device, a cooling system, and a charging device. The cooling device comprises of: multiple cooling modules (1), each cooling module (1) having a containing chamber (101) for containing cooling liquid, and a first pipe joint (13) and a second pipe joint (11a) communicated with the containing chamber (101); and a multi-channel pipe joint component (2) comprising multiple first mating pipe joints (21) interconnected with each other. The multiple first mating pipe joints (21) of the multi-channel pipe joint component (2) are respectively connected to the first pipe joints (13) of the multiple cooling modules (1), so that the containing chambers (101) of the multiple cooling modules (1) are connected to each other through the multi-channel pipe joint component (2), the second pipe joints (11a) of the multiple cooling modules (1) are used to connect with cooling core pipes (31) of multiple charging cables (3) respectively, so that the cooling liquid can flow through the containing chambers (101) of the multiple cooling modules (1) and the cooling core pipes (31) of the multiple charging cables (3). In the present invention, the cooling liquid can flow in and out through the cooling core pipe of the charging cable without the need for inlet and outlet pipes, simplifying the structure of the cooling device, reducing assembly steps, and lowering manufacturing costs.

## Description

### CROSS-REFERENCE TO RELATED APPLICATION

This application claims the benefit of Chinese Patent Application No. CN202311869732.X filed on December 29, 2023 in the State Intellectual Property Office of China, the whole disclosure of which is incorporated herein by reference.

### BACKGROUND OF THE INVENTION

### Field of the Invention

The present invention relates to a cooling device, a cooling system comprising the cooling device and a charging device comprising the cooling system.

### Description of the Related Art

In the prior art, the charging seat usually includes a charging seat housing, a charging terminal set in the charging seat housing, and a charging cable electrically connected to the charging terminal. In order to improve the charging speed, it is necessary to increase the charging current. Currently, the charging current requirement is as high as 600A, and it may be further increased to 1000A in the future. When this high current flows through the charging cable and charging terminal, it will cause a sharp rise in the temperature inside the charging seat housing and the temperature of the charging cable. In order to prevent excessive temperature rise, in the prior art, the diameter of the charging cable is usually increased, but this will increase the volume and weight of the charging seat product, and lead to higher costs.

In order to improve the cooling performance of the charging seat, a liquid cooled charging seat has recently been proposed. There is a containing chamber for accommodating cooling liquid in the housing of the liquid cooled charging seat, which has an inlet pipe joint for connecting with the cooling liquid inlet pipe and an outlet pipe joint for connecting with the cooling liquid outlet pipe. Therefore, in these technical solutions, separate cooling liquid inlet and outlet pipes need to be provided, and the cooling liquid inlet and outlet pipes also need to be connected to the inlet and outlet pipe joints of the containing chamber respectively. This will lead to an increase in the cost and complex assembly of the liquid cooled charging seat.

### SUMMARY OF THE INVENTION

The present invention has been made to overcome or alleviate at least one aspect of the above mentioned disadvantages.

According to an aspect of the present invention, there is provided a cooling device. The cooling device comprises of: multiple cooling modules, each cooling module having a containing chamber for containing cooling liquid, and a first pipe joint and a second pipe joint communicated with the containing chamber; and a multi-channel pipe joint component comprising multiple first mating pipe joints interconnected with each other. The multiple first mating pipe joints of the multi-channel pipe joint component are respectively connected to the first pipe joints of the multiple cooling modules, so that the containing chambers of the multiple cooling modules are connected to each other through the multi-channel pipe joint component; the second pipe joints of the multiple cooling modules are used to connect with cooling core pipes of multiple charging cables respectively, so that the cooling liquid can flow through the containing chambers of the multiple cooling modules and the cooling core pipes of the multiple charging cables.

According to an exemplary embodiment of the present invention, the cooling module comprises a cooling box for defining the containing chamber, the cooling box comprises a box body with an opening and a cover plate installed on the opening of the box body; the cover plate is used for thermal contact with a welding end of a charging terminal to transfer the heat of the charging terminal to the cooling liquid inside the cooling box.

According to another exemplary embodiment of the present invention, the first pipe joint and the second pipe joint are integrally formed with the box body, so that the first pipe joint and the second pipe joint become part of the box body.

According to another exemplary embodiment of the present invention, the cover plate is an insulation component that can conduct heat but not electricity, and the box body is an insulation component that cannot conduct heat and electricity.

According to another exemplary embodiment of the present invention, the cover plate is a ceramic component that can conduct heat but not electricity, and the box body is an injection molded component that cannot conduct heat and electricity.

According to another exemplary embodiment of the present invention, threaded holes are respectively formed in the box body and the cover plate, and the cooling module further comprises a threaded connection piece, which is connected to the threaded holes in the box body and the cover plate to fix the cover plate to the box body.

According to another exemplary embodiment of the present invention, the cooling module further comprises a sealing ring which is set around the opening of the box body and compressed between the box body and the cover plate to achieve sealing between the box body and the cover plate.

According to another exemplary embodiment of the present invention, a sealing ring installation groove is formed on at least one of the box body and the cover plate, and the sealing ring is positioned and installed in the sealing ring installation groove.

According to another exemplary embodiment of the present invention, the cooling module further comprises a fixing device which is installed on the box body of the cooling box, used to fix the welding end of the charging terminal to the outside of the cover plate of the cooling box, so that the welding end of the charging terminal is in reliable thermal contact with the cover plate.

According to another exemplary embodiment of the present invention, the fixing device comprises a U-shaped component and a bolt, wherein the U-shaped component is fixed to the box body, and a threaded connection hole is formed through the U-shaped component, the bolt is connected to the threaded connection hole and pushes the welding end of the charging terminal onto the cover plate of the cooling box, so that there is a predetermined contact force between the welding end of the charging terminal and the cover plate of the cooling box.

According to another exemplary embodiment of the present invention, the U-shaped component comprises: a pair of side plates which are respectively fixed to both sides of the box body; and a top plate connected between the top of the pair of side plates. The top plate of the U-shaped component faces the conductor end of the charging cable welded to the welding end of the charging terminal, and the threaded connection hole is formed in the top plate of the U-shaped component, the bolt is pressed against the conductor end of the charging cable to push the welding end of the charging terminal onto the cover plate of the cooling box through the conductor end of the charging cable.

According to another exemplary embodiment of the present invention, the pair of side plates of the U-shaped component are respectively formed with snap slots, and protrusions are respectively formed on both sides of the box body of the cooling box, the protrusions are engaged with the snap slots to fix the pair of side plates of the U-shaped component to both sides of the box body of the cooling box.

According to another aspect of the present invention, there is provided a cooling system. The cooling system comprises of the above cooling device; and multiple charging cables, each charging cable comprising a cooling core pipe and a conductor. The ends of the cooling core pipes of the multiple charging cables are respectively connected to the second pipe joints of the multiple cooling modules of the cooling device, one of the cooling core pipes of the multiple charging cables is used as a cooling liquid inlet pipe, while the rest are used as cooling liquid outlet pipes.

According to an exemplary embodiment of the present invention, the conductor of the charging cable is tubular, and the cooling core pipe is set in the conductor, the charging cable also includes an outer insulation layer wrapped around the outside of the conductor.

According to another exemplary embodiment of the present invention, the conductor has a conductor end exposed from the outer insulation layer, which is used for welding to the welding end of the charging terminal; the end of the cooling core pipe is exposed from the outer insulation layer and connected to the second pipe joint of the cooling module.

According to another aspect of the present invention, there is provided a charging device.

The charging device comprises of: a housing; multiple charging terminals which are arranged in the housing; and the above cooling system installed in the housing. The welding ends of the multiple charging terminals are respectively welded to the conductor ends of the multiple charging cables of the cooling system and respectively fixed to the cover plates of the cooling boxes of the multiple cooling modules, so that the heat of the charging terminal can be transferred to the cooling liquid inside the cooling box through the cover plate of the cooling box.

According to an exemplary embodiment of the present invention, the charging device is a charging seat suitable for mating with a charging gun, and the charging terminal is suitable for mating with a mating terminal in the charging gun.

According to another exemplary embodiment of the present invention, the charging device is a charging gun suitable for mating with a charging seat, and the charging terminal is suitable for mating with a mating terminal in the charging seat.

According to another exemplary embodiment of the present invention, the welding end of the charging terminal and the conductor end of the charging cable are flat and stacked and welded together.

In the aforementioned exemplary embodiments according to the present invention, the containing chambers of multiple cooling modules are interconnected and adapted to be respectively connected to the cooling core pipes of multiple charging cables, so that cooling liquid can flow in and out through the cooling core pipes of the charging cables without providing separate cooling liquid inlet and outlet pipes, simplifying the structure of the cooling device, reducing assembly steps, and lowering manufacturing costs.

### BRIEF DESCRIPTION OF THE DRAWINGS

The above and other features of the present invention will become more apparent by describing in detail exemplary embodiments thereof with reference to the accompanying drawings, in which:
Figure 1 shows an illustrative perspective view of a cooling device according to an exemplary embodiment of the present invention, wherein the charging terminal and charging cable are shown;
Figure 2 shows a vertical sectional view of a cooling device according to an exemplary embodiment of the present invention, wherein the charging terminal and charging cable are shown;
Figure 3 shows another vertical sectional view of a cooling device according to an exemplary embodiment of the present invention, wherein the charging terminal and charging cable are shown; and
Figure 4 shows a horizontal sectional view of a cooling device according to an exemplary embodiment of the present invention, wherein the charging terminal and charging cable are shown.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided a cooling device. The cooling device comprises of multiple cooling modules, each cooling module having a containing chamber for containing cooling liquid, and a first pipe joint and a second pipe joint communicated with the containing chamber; and a multi-channel pipe joint component comprising multiple first mating pipe joints interconnected with each other. The multiple first mating pipe joints of the multi-channel pipe joint component are respectively connected to the first pipe joints of the multiple cooling modules, so that the containing chambers of the multiple cooling modules are connected to each other through the multi-channel pipe joint component; the second pipe joints of the multiple cooling modules are used to connect with cooling core pipes of multiple charging cables respectively, so that the cooling liquid can flow through the containing chambers of the multiple cooling modules and the cooling core pipes of the multiple charging cables.

According to another general concept of the present invention, there is provided a cooling system. The cooling system comprises of the above cooling device; and multiple charging cables, each charging cable comprising a cooling core pipe and a conductor. The ends of the cooling core pipes of the multiple charging cables are respectively connected to the second pipe joints of the multiple cooling modules of the cooling device, one of the cooling core pipes of the multiple charging cables is used as a cooling liquid inlet pipe, while the rest are used as cooling liquid outlet pipes.

According to another general concept of the present invention, there is provided a charging device. The charging device comprises of a housing; multiple charging terminals which are arranged in the housing; and the above cooling system installed in the housing. The welding ends of the multiple charging terminals are respectively welded to the conductor ends of the multiple charging cables of the cooling system and respectively fixed to the cover plates of the cooling boxes of the multiple cooling modules, so that the heat of the charging terminal can be transferred to the cooling liquid inside the cooling box through the cover plate of the cooling box.

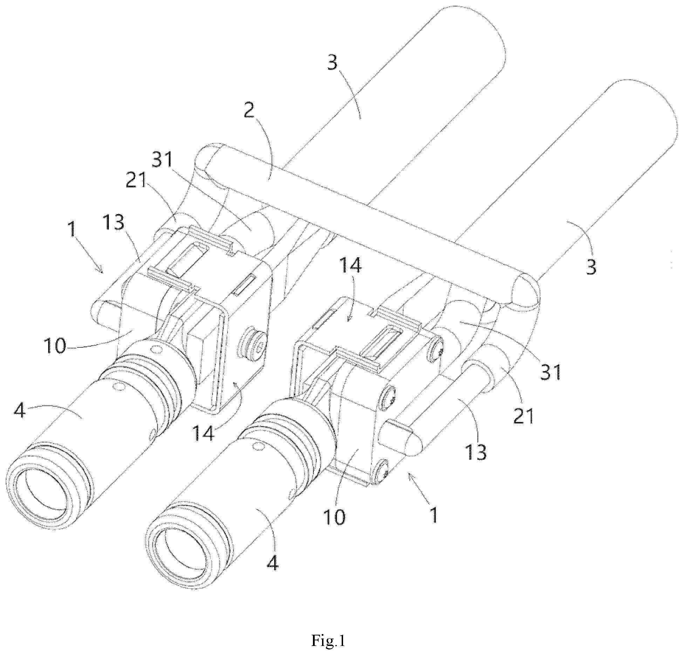

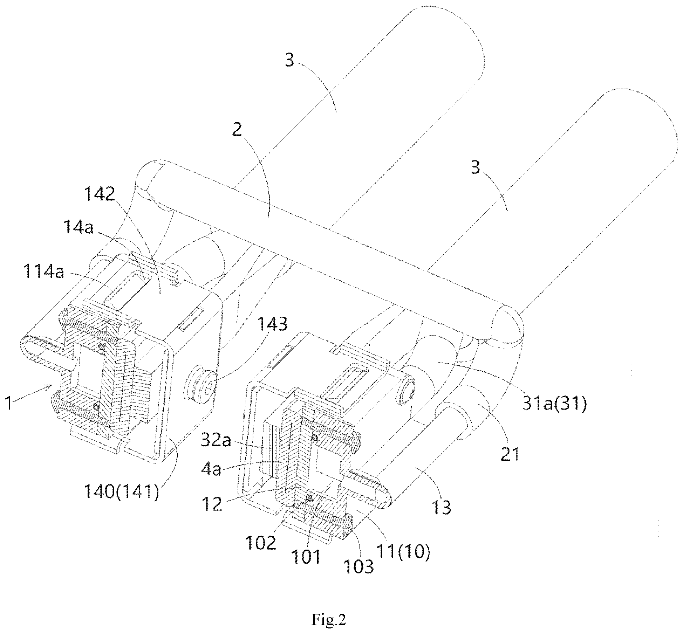

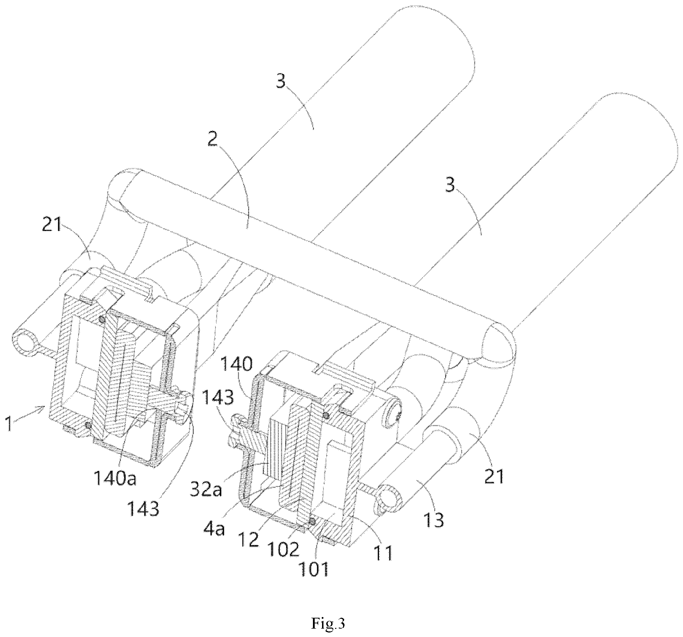

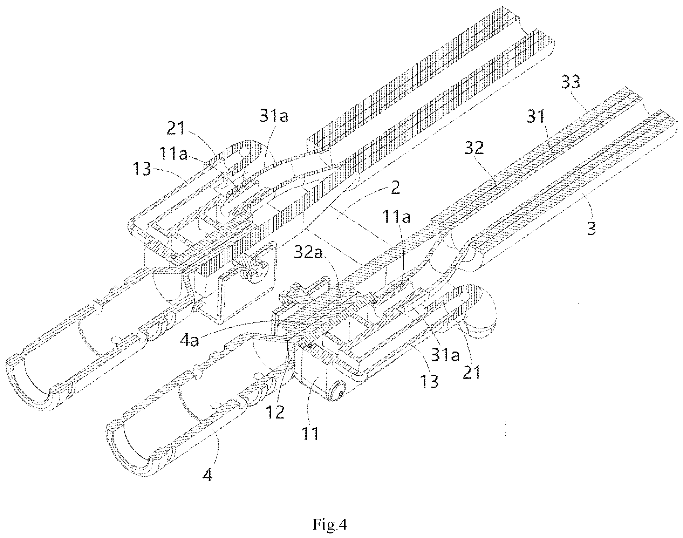

Figure 1 shows an illustrative perspective view of a cooling device according to an exemplary embodiment of the present invention, wherein a charging terminal 4 and a charging cable 3 are shown; Figure 2 shows a vertical sectional view of a cooling device according to an exemplary embodiment of the present invention, wherein the charging terminal 4 and the charging cable 3 are shown; Figure 3 shows another vertical sectional view of a cooling device according to an exemplary embodiment of the present invention, in which charging terminal 4 and charging cable 3 are shown; Figure 4 shows a horizontal sectional view of a cooling device according to an exemplary embodiment of the present invention, wherein the charging terminal 4 and the charging cable 3 are shown.

As shown in Figures 1 to 4, in an exemplary embodiment of the present invention, a cooling device is disclosed. The cooling device mainly includes: multiple cooling modules 1 and a multi-channel pipe joint component 2. Each cooling module 1 has a containing chamber 101 for accommodating cooling liquid, and a first pipe joint 13 and a second pipe joint 11a communicated with the containing chamber 101. The multi-channel pipe joint component 2 includes multiple first mating pipe joints 21 interconnected with each other. The multiple first mating pipe joints 21 of the multi-channel pipe joint component 2 are respectively connected to the first pipe joints 13 of the multiple cooling modules 1, so that the containing chambers 101 of the multiple cooling modules 1 are connected to each other through the multi-channel pipe joint component 2. The second pipe joints 11a of multiple cooling modules 1 are used to connect with the cooling core pipes 31 of multiple charging cables 3 respectively, so that the cooling liquid can flow through the containing chambers 101 of multiple cooling modules 1 and the cooling core pipes 31 of multiple charging cables 3.

As shown in Figures 1 to 4, in the illustrated embodiment, the cooling module 1 includes a cooling box 10, and the inner cavity of the cooling box 10 constitutes the aforementioned containing chamber 101. The cooling box 10 includes a box body 11 with an opening and a cover plate 12 installed on the opening of the box body 11. The cover plate 12 is used to make thermal contact with the welding end 4a of the charging terminal 4, in order to transfer the heat of the charging terminal 4 to the cooling liquid inside the cooling box 10.

As shown in Figures 1 to 4, in the illustrated embodiment, the first pipe joint 13 and the second pipe joint 11a are integrally formed with the box body 11, so that the first pipe joint 13 and the second pipe joint 11a become part of the box body 11.

As shown in Figures 1 to 4, in the illustrated embodiment, the cover plate 12 is an insulation component that can conduct heat but not electricity, and the box body 11 is an insulation component that cannot conduct heat and electricity. In an exemplary embodiment of the present invention, the cover plate 12 is a ceramic component that can conduct heat but not electricity, and the box body 11 is an injection molded component that cannot conduct heat and electricity.

As shown in Figures 1 to 4, in the illustrated embodiment, threaded holes are formed in the box body 11 and the cover plate 12, respectively. The cooling module 1 also includes a threaded connection piece 103, which is connected to the threaded holes in the box body 11 and the cover plate 12 to fix the cover plate 12 to the box body 11.

As shown in Figures 1 to 4, in the illustrated embodiment, the cooling module 1 further comprises a sealing ring 102, which is arranged around the opening of the box body 11 and compressed between the box body 11 and the cover plate 12 to achieve sealing between the box body 11 and the cover plate 12.

As shown in Figures 1 to 4, in the illustrated embodiment, a sealing ring installation groove is formed on at least one of the box body 11 and the cover plate 12, and the sealing ring 102 is positioned and installed in the sealing ring installation groove.

As shown in Figures 1 to 4, in the illustrated embodiment, the cooling module 1 further comprises a fixing device 14, which is installed on the box body 11 of the cooling box 10, for fixing the welding end 4a of the charging terminal 4 to the outer side of the cover plate 12 of the cooling box 10, so that the welding end 4a of the charging terminal 4 is reliably in thermal contact with the cover plate 12.

As shown in Figures 1 to 4, in the illustrated embodiment, the fixing device 14 includes a U-shaped component 140 and a bolt 143. The U-shaped component 140 is fixed to the box body 11, and a threaded connection hole 140a is formed through the U-shaped component 140. The bolt 143 is connected to the threaded connection hole 140a and pushes the welding end 4a of the charging terminal 4 against the cover plate 12 of the cooling box 10, so that there is a predetermined contact force between the welding end 4a of the charging terminal 4 and the cover plate 12 of the cooling box 10.

As shown in Figures 1 to 4, in the illustrated embodiment, the U-shaped component 140 includes a pair of side plates 142 and a top plate 141. The pair of side plates 142 are respectively fixed to both sides of the box body 11. The top plate 141 is connected between the top of the pair of side plates 142. The top plate 141 of the U-shaped component 140 faces the conductor end 32a of the charging cable 3 welded to the welding end 4a of the charging terminal 4, and a threaded connection hole 140a is formed in the top plate 141 of the U-shaped component 140. The bolt 143 is pressed against the conductor end 32a of charging cable 3 to push the welding end 4a of charging terminal 4 onto the cover plate 12 of cooling box 10 through the conductor end 32a of charging cable 3.

As shown in Figures 1 to 4, in the illustrated embodiment, snap slots 14a are respectively formed on the pair of side plates of the U-shaped component 140, and protrusions 114a are formed on both sides of the box body 11 of the cooling box 10. The protrusions 114a are engaged with the snap slots 14a to fix the pair of side plates of the U-shaped component 140 to the two sides of the box body 11 of the cooling box 10.

As shown in Figures 1 to 4, in another exemplary embodiment of the present invention, a cooling system is also disclosed. The cooling system mainly includes the aforementioned cooling device and multiple charging cables 3. Each charging cable 3 includes a cooling core pipe 31 and a conductor 32. The ends 31a of the cooling core pipes 31 of multiple charging cables 3 are respectively connected to the second pipe joints 11a of multiple cooling modules 1 of the cooling device. One of the cooling core pipes 31 of multiple charging cables 3 is used as a cooling liquid inlet pipe, while the rest are used as cooling liquid outlet pipes.

As shown in Figures 1 to 4, in the illustrated embodiment, the conductor 32 of the charging cable 3 is tubular, and the cooling core pipe 31 is set in the conductor 32. The charging cable 3 also includes an outer insulation layer 33 wrapped around the outside of the conductor 32.

As shown in Figures 1 to 4, in the illustrated embodiment, the conductor 32 of the charging cable 3 has a conductor end 32a exposed from the outer insulation layer 33, which is used for welding to the welding end 4a of the charging terminal 4. The end of the cooling core pipe 31 of the charging cable 3 is exposed from the outer insulation layer 33 and connected to the second pipe joint 11a of the cooling module 1.

As shown in Figures 1 to 4, in another exemplary embodiment of the present invention, a charging device is also disclosed. The charging device mainly includes a housing (not shown), multiple charging terminals 4, and the aforementioned cooling system. Multiple charging terminals 4 and the cooling system are installed in the housing. The welding ends 4a of multiple charging terminals 4 are respectively welded to the conductor ends 12a of multiple charging cables 3 of the cooling system and respectively fixed to the cover plates 12 of the cooling boxes 10 of multiple cooling modules 1, so that the heat of the charging terminal 4 can be transferred to the cooling liquid inside the cooling box 10 through the cover plate 12 of the cooling box 10.

As shown in Figures 1 to 4, in the illustrated embodiment, the charging device is a charging seat suitable for mating with a charging gun, and the charging terminal 4 is suitable for mating with a mating terminal in the charging gun. However, the present invention is not limited to the illustrated embodiment. For example, in another exemplary embodiment of the present invention, the charging device is a charging gun suitable for mating with a charging seat, and the charging terminal 4 is suitable for mating with a mating terminal in the charging seat.

As shown in Figures 1 to 4, in the illustrated embodiment, the welding end 4a of the charging terminal 4 and the conductor end 32a of the charging cable 3 are flat and stacked and welded together. For example, they can be welded together using ultrasonic waves.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles and spirit of the disclosure, the scope of which is defined in the claims and their equivalents.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A cooling device, comprising:
multiple cooling modules (1), each cooling module (1) having a containing chamber (101) for containing cooling liquid, and a first pipe joint (13) and a second pipe joint (11a) communicated with the containing chamber (101); and
a multi-channel pipe joint component (2) comprising multiple first mating pipe joints (21) interconnected with each other,
wherein the multiple first mating pipe joints (21) of the multi-channel pipe joint component (2) are respectively connected to the first pipe joints (13) of the multiple cooling modules (1), so that the containing chambers (101) of the multiple cooling modules (1) are connected to each other through the multi-channel pipe joint component (2),
wherein the second pipe joints (11a) of the multiple cooling modules (1) are used to connect with cooling core pipes (31) of multiple charging cables (3) respectively, so that the cooling liquid can flow through the containing chambers (101) of the multiple cooling modules (1) and the cooling core pipes (31) of the multiple charging cables (3).

2. The cooling device according to claim 1,
wherein the cooling module (1) comprises a cooling box (10) for defining the containing chamber (101), the cooling box (10) comprises a box body (11) with an opening and a cover plate (12) installed on the opening of the box body (11);
wherein the cover plate (12) is used for thermal contact with a welding end (4a) of a charging terminal (4) to transfer the heat of the charging terminal (4) to the cooling liquid inside the cooling box (10).

3. The cooling device according to claim 2,
wherein the first pipe joint (13) and the second pipe joint (11a) are integrally formed with the box body (11), so that the first pipe joint (13) and the second pipe joint (11a) become part of the box body (11).

4. The cooling device according to claim 3,
wherein the cover plate (12) is an insulation component that can conduct heat but not electricity, and the box body (11) is an insulation component that cannot conduct heat and electricity.

5. The cooling device according to claim 2,
wherein threaded holes are respectively formed in the box body (11) and the cover plate (12), and the cooling module (1) further comprises a threaded connection piece (103), which is connected to the threaded holes in the box body (11) and the cover plate (12) to fix the cover plate (12) to the box body (11).

6. The cooling device according to claim 2,
wherein the cooling module (1) further comprises:
a sealing ring (102) which is set around the opening of the box body (11) and compressed between the box body (11) and the cover plate (12) to achieve sealing between the box body (11) and the cover plate (12),
wherein a sealing ring installation groove is formed on at least one of the box body (11) and the cover plate (12), and the sealing ring (102) is positioned and installed in the sealing ring installation groove.

7. The cooling device according to claim 2,
wherein the cooling module (1) further comprises:
a fixing device (14) which is installed on the box body (11) of the cooling box (10), used to fix the welding end (4a) of the charging terminal (4) to the outside of the cover plate (12) of the cooling box (10), so that the welding end (4a) of the charging terminal (4) is in reliable thermal contact with the cover plate (12).

8. The cooling device according to claim 7,
wherein the fixing device (14) comprises a U-shaped component (140) and a bolt (143), wherein the U-shaped component (140) is fixed to the box body (11), and a threaded connection hole (140a) is formed through the U-shaped component (140), the bolt (143) is connected to the threaded connection hole (140a) and pushes the welding end (4a) of the charging terminal (4) onto the cover plate (12) of the cooling box (10), so that there is a predetermined contact force between the welding end (4a) of the charging terminal (4) and the cover plate (12) of the cooling box (10).

9. The cooling device according to claim 8,
wherein the U-shaped component (140) comprises:
a pair of side plates (142) which are respectively fixed to both sides of the box body (11); and
a top plate (141) connected between the top of the pair of side plates (142),
wherein the top plate (141) of the U-shaped component (140) faces the conductor end (32a) of the charging cable (3) welded to the welding end (4a) of the charging terminal (4), and the threaded connection hole (140a) is formed in the top plate (141) of the U-shaped component (140),
wherein the bolt (143) is pressed against the conductor end (32a) of the charging cable (3) to push the welding end (4a) of the charging terminal (4) onto the cover plate (12) of the cooling box (10) through the conductor end (32a) of the charging cable (3).

10. The cooling device according to claim 9,
wherein the pair of side plates (142) of the U-shaped component (140) are respectively formed with snap slots (14a), and protrusions (114a) are respectively formed on both sides of the box body (11) of the cooling box (10), the protrusions (114a) are engaged with the snap slots (14a) to fix the pair of side plates (142) of the U-shaped component (140) to both sides of the box body (11) of the cooling box (10).

11. A cooling system, comprising:
the cooling device as claimed in any one of claims 1-10; and
multiple charging cables (3), each charging cable (3) comprising a cooling core pipe (31) and a conductor (32),
wherein the ends (31a) of the cooling core pipes (31) of the multiple charging cables (3) are respectively connected to the second pipe joints (11a) of the multiple cooling modules (1) of the cooling device,
wherein one of the cooling core pipes (31) of the multiple charging cables (3) is used as a cooling liquid inlet pipe, while the rest are used as cooling liquid outlet pipes.

12. The cooling system according to claim 11,
wherein the conductor (32) of the charging cable (3) is tubular, and the cooling core pipe (31) is set in the conductor (32), the charging cable (3) also includes an outer insulation layer (33) wrapped around the outside of the conductor (32).

13. The cooling system according to claim 12,
wherein the conductor (32) has a conductor end (32a) exposed from the outer insulation layer (33), which is used for welding to the welding end (4a) of the charging terminal (4);
wherein the end (31a) of the cooling core pipe (31) is exposed from the outer insulation layer (33) and connected to the second pipe joint (11a) of the cooling module (1).

14. A charging device, comprising:
a housing;
multiple charging terminals (4) which are arranged in the housing; and
the cooling system according to any one of claims 11-13, installed in the housing,
wherein the welding ends (4a) of the multiple charging terminals (4) are respectively welded to the conductor ends (32a) of the multiple charging cables (3) of the cooling system and respectively fixed to the cover plates (12) of the cooling boxes (10) of the multiple cooling modules (1), so that the heat of the charging terminal (4) can be transferred to the cooling liquid inside the cooling box (10) through the cover plate (12) of the cooling box (10).

15. The charging device according to claim 14,
wherein the charging device is a charging seat suitable for mating with a charging gun, and the charging terminal (4) is suitable for mating with a mating terminal in the charging gun; or
wherein the charging device is a charging gun suitable for mating with a charging seat, and the charging terminal (4) is suitable for mating with a mating terminal in the charging seat.
